# NEUE EUROPÄISCHE PATENTSCHRIFT

(11) **EP 0 724 228 B2**
(45) Veröffentlichungstag und Bekanntmachung des Hinweises auf die Entscheidung über den Einspruch: **05.04.2006**
(45) Hinweis auf die Patenterteilung: 09.04.2003
(21) Anmeldenummer: 96101004.8
(22) Anmeldetag: 24.01.1996
(51) Int. Cl.: G06K 19/077

(54) **Verfahren zur Montage eines elektronischen Moduls in einem Kartenkörper**
Method for assembling an electronic module in a card body
Procédé de montage d'un module électronique dans un corps de carte

(30) Priorität: 26.01.1995 DE 19502398
(43) Veröffentlichungstag der Anmeldung: 31.07.1996
(73) Patentinhaber: Giesecke & Devrient GmbH, 81677 München (DE)
(72) Erfinder: Tarantino, Thomas, D-80636 München (DE)
(74) Vertreter: Klunker . Schmitt-Nilson . Hirsch

(56) Entgegenhaltungen:
- EP-A- 0 493 738
- FR-A- 2 701 139
- US-A- 4 737 620
- PATENT ABSTRACTS OF JAPAN vol. 13, no. 219 (P-875), 23.Mai 1989 & JP 01 033749 A (TOSHIBA CORP), 3.Februar 1989,
- Schriftliches Angebot der Firma Mühlbauer GmbH, Roding, an die Firma Gemplus, F-13881 Gemenos Cedex, datiert 22.11.1994, betreffend "COMPACT MACHINES FOR ASSEMBLING SMART CARDS"

## Beschreibung

Die Erfindung betrifft ein Verfahren zur Montage eines elektronischen Moduls in der Aussparung eines Kartenkörpers unter Anwendung von Wärme und Druck.

Verfahren der eingangs genannten Art sind in der Fachwelt bekannt. Sie dienen zur Herstellung von elektronischen Datenträgern, etwa in Form von IC-Karten, die beispielsweise als Ausweis-, Kredit- oder auch Wertkarten eingesetzt werden. Das in einer Aussparung mit dem Kartenkörper verbundene elektronische Modul umfaßt zumindest einen integrierten Schaltkreis und Kopplungselemente, die leitend mit dem integrierten Schaltkreis verbunden sind. Der so aufgebaute Datenträger kann über die Kopplungselemente mit einem dafür vorgesehenen externen Gerät kommunizieren.

EP 493 738 A1 beschreibt einen nach obengenanntem Verfahren hergestellten Datenträger. Der Datenträgerbesteht aus einem Kartenkörper und einem elektronischen Modul, das in einer zweistufigen Aussparung des Kartenkörpers mit diesem verklebt ist. Das elektronische Modul weist einen Trägerfilm mit darauf aufgebrachten Kontaktflächen zur berührenden Kontaktierung des elektronischen Moduls auf. Ein integrierter Schaltkreis ist auf der den Kontaktflächen abgewandten Seite des Trägerfilms befestigt und leitend mit den Kontaktflächen verbunden. Integrierter Schaltkreis und Verbindungsleitungen sind von einer Vergußmasse umgeben. Auf der den Kontaktflächen gegenüberliegenden Seite ist weiterhin eine Folie aus thermoaktivierbarem Kleber aufgebracht. Das elektronische Modul wird in der zweistufigen Aussparung des Kartenkörpers verklebt, indem es mittels eines beheizten Stempels in die Aussparung des Kartenkörpers gepreßt wird. Durch die Erwärmung schmilzt der thermoaktivierbare Kleber und verklebt dabei das elektronische Modul mit dem Kartenkörper. Die Kartenrückseite liegt bei dem Vorgang auf einem Kühlstempel auf.

US 4,737,620 offenbart ein Verfahren zur Herstellung eines Datenträgers sowie einen dadurch erzeugten Datenträger. Der Datenträger besteht aus einem Kartenkörper, in dessen Aussparung ein elektronisches Modul eingebaut wird. Das elektronische Modul weist ein Trägersubstrat auf, auf dem sich Kontaktflächen zurberührenden Kontaktierung befinden. Auf dem Substrat ist ein integrierter Schaltkreis befestigt und leitend mit den Kontaktflächen verbunden. Das Substrat weist ferner Fenster auf, mit Hilfe derer das Modul mit dem Kartenkörper verbunden wird. Dazu wird das Modul mittels eines beheizbaren Stempels in die Aussparung des Kartenkörpers gepreßt, wodurch das Kartenmaterial im Bereich des elektronischen Moduls erweicht und sich in die dafür vorgesehenen Fenster des Trägersubstrats eindrückt und so das Modul mit dem Kartenkörper verbindet.

FR 2 701 139 offenbart desweiteren ein Verfahren zur Montage eines elektronischen Moduls, bei dem das zu montierende elektronische Modul unter Ausübung von Wärme und Druck in einer Aussparung eines Kartenkörpers fixiert wird. Zur Fixierung kann ein thermoaktivierbarer Kleber eingesetzt werden. Die Zufuhr von Wärme und Druck sollen in Etappen erfolgen, wobei diese Etappen verfahrenstechnisch zu einem einzelnen Arbeitsschritt verkoppelt sind und an einer einzelnen Bearbeitungseinrichtung durchgeführt werden. Der Moduleinbau erfolgt unter Verdrängung von Kartenkörpermaterial. Die dadurch bedingten Unebenheiten an der Kartenkörperoberfläche werden durch Druckausübung planiert.

Die bekannten Verfahren zur Montagevon Modulen in Karten sind in der Regel in einen Fertigungsprozeß integriert, in dem zeitlich vor, aber auch nach dem Montagevorgang andere Verfahrensschritte durchgeführt werden. Die Prozesse unterliegen dabei einer festen Taktzeit, die zur Optimierung des Durchsatzes so gering wie möglich gewählt werden sollte. Entsprechend der resultierenden kurzen Taktzeit muß für die Montage des Moduls eine relativ hohe Temperatur gewählt werden, um den thermoaktivierbaren Kleber bzw. das Kartenmaterial genügend zu erweichen. Daraus ergeben sich allerdings auch relativ hohe thermische Belastungen für das elektronische Modul und das Kartenmaterial. So werden beispielsweise die Anschlußpunkte der leitenden Verbindungen vor allem an den Kontaktflächen stark erwärmt, was zu einer Schwächung der Verbindungen führen kann. Darüber hinaus verursacht die starke Erwärmung Spannungen im Material des Kartenkörpers, so daß die dem elektronischen Modul abgewandte Seite des Kartenkörpers vor allem im Bereich des dünnen Bodens der Aussparung Verformungen aufweist. Aus den genannten Gründen kann deshalb die Taktzeit nicht beliebig verkürzt werden.

Aufgabe der vorliegenden Erfindung ist es deshalb, ein Verfahren sowie eine Vorrichtung zur Montage eines elektronischen Moduls im Kartenkörper anzugeben, bei dem die thermische Belastung des elektronischen Moduls und des Kartenkörpers bei gleichzeitig höherem Durchsatz verringert werden kann.

Die Aufgabe wird gelöst durch ein Verfahren mit den Merkmalen des Anspruchs 1. Die Aufgabe wird weiterhin gelöst durch eine Vorrichtung mit den Merkmalen des Anspruchs 5.

Der Grundgedanke der Erfindung ist darin zu sehen, daß das Verfahren zur Montage des elektronischen Moduls in dem Datenträger in mehrere Schritte unterteilt wird, die an hintereinander angeordneten Bearbeitungseinrichtungen ausgeführt werden. Dabei wird entweder die Erwärmung es elektronischen Moduls, des Kartenkörpers und gegebenenfalls des thermoaktivierbaren Klebers auf mehrere Arbeitsschritte verteilt oder aber in wenigstens einem ersten Schritt gezielt der thermoaktivierbare Kleber erwärmt und das elektronische Modul in einem nachfolgenden Schritt unter Druck und Wärme montiert.

Die Vorteile der Erfindung sind vor allem darin zu sehen, daß die thermische Belastung sowohl des Moduls wie der Karte vermindert wird. Hieraus ergibt sich für den Datenträger eine höhere Benutzungsdauer. Darüber hinaus weist der Kartenkörper weniger Verformungen auf, was die optische Qualität des Datenträgers steigert. Ein weiterer Vorteil liegt darin, daß der Durchsatz der angefertigten Karten erhöht werden kann, was zu einer Verminderung der Herstellungskosten führt.

Das erfindungsgemäße Verfahren sieht vor, die Montage des elektronischen Moduls in der Aussparung des Kartenkörpers in wenigstens zwei aufeinanderfolgenden Schritten herzustellen.

Hierbei werden das elektronische Modul, der Kartenkörperund gegebenenfalls derthermoaktivierbare Kleber in einem ersten Schritt vorgewärmt, bevor in einem weiteren Schritt die Montage unter Druck und Wärme erfolgt. Vorzugsweise sollte die Temperatur, mit der das elektronische Modul beaufschlagt wird, im ersten Arbeitsschritt so gering wie möglich gehalten werden und somit unter der des letzten Arbeitsschrittes liegen, um so die thermische Belastung des elektronischen Moduls und des Kartenkörpers, bedingt durch die starken Temperaturunterschiede, so gering wie möglich zu halten. Das elektronische Modul und der Kartenkörper können in einem zusätzlichen Arbeitsschritt nach der Montage gekühlt werden.

Alternativ wird in wenigstens einer Vorstufe gezielt der thermoaktivierbare Kleber erwärmt und in einer weiteren Stufe das elektronische Modul unter Druck und Wärme montiert. Die gezielte Erwärmung des thermoaktivierbaren Klebers erfolgt durch Energiezufuhr von der Schweißstation, wobei die zugeführte Energie vorwiegend vom thermoaktivierbaren Kleber absorbiert wird.

Ein nach dem erfindungsgemäßen Verfahren herstellbarer Datenträger weist einen Kartenkörper und ein in einer Aussparung des Kartenkörpers befindliches Modul auf. Das elektronische Modul umfaßtwenigstens ein Trägersubstrat, beispielsweise in Form eines Trägerfilms, mit Kopplungselementen, wie beispielsweise Kontaktflächen, auf dem ein integrierter Schaltkreis fixiert und leitend mit den Kopplungselementen verbunden ist. Das Trägersubstrat ist entweder durch einen thermoaktivierbaren Kleber oder durch das Kartenmaterial selber auf dem Kartenkörper fixiert. Im letzteren Fall weist das Trägersubstrat Fenster auf, in die beim Verpressen des elektronischen Moduls mit dem Kartenkörper das erweichte Kartenmaterial eindringen kann. Wahlweise können der integrierte Schaltkreis und die leitenden Verbindungen mit einer Vergußmasse in der dem Fachmann hinreichend bekannten Weise umgeben sein.

Eine Schweißstation zur Durchfûhrung des erfindungsgemässen Verfahrens besitzt wenigstens eine erste Bearbeitungseinrichtung in Form eines beheizbaren Stempels sowie einer zugehörigen Unterlage, zwischen denen unter Druck und Wärme das elektronische Modul in der Aussparung des Kartenkörpers montiert wird; die Unterlage kann beispielsweise in Form eines Kühlstempels ausgeführt sein. Ferner umfaßt sie mindestens eine weitere Bearbeitungseinrichtung zum Vorwärmen des elektronischen Moduls und des Kartenkörpers. Bei der weiteren Erwärmungseinrichtung handelt es sich beispielsweise um einen weiteren beheizbaren Stempel mit zugehöriger Unterlage oder um eine Heizung, die den Kartenkörper und das elektronische Modul zumindest teilweise umgibt. Zusätzlich kann eine Kühleinrichtung vorgesehen werden, die das elektronische Modul wie auch den Kartenkörper nach der Montage abkühlt. Eine derartige Kühleinrichtung kann beispielsweise aus einem weiteren Stempel mit zugehöriger Unterlage bestehen, wobei vorzugsweise beide Komponenten gekühlt werden. Die Schweißstation besitzt weiterhin eine Transporteinrichtung, die den Kartenkörper mit dem in der Aussparung befindlichen Modul im Systemtakt zu den Einrichtungen der Schweißstation transportiert. Es kann sich hierbei beispielsweise um ein Transportband handeln.

Weitere Vorteile und Merkmale der Erfindung ergeben sich aus den Figuren. Hierbei zeigen
- Fig. 1: einen Datenträger mit eingebautem Modul,
- Fig. 2: Schnitt des Datenträgers nach Fig. 1 entlang der Linie A-B,
- Fig. 3: Einzelkomponenten einer erfindungsgemäßen Schweißstation,
- Fig. 4: Aufsicht auf einen Datenträger, der sich auf Transportbändern befindet.

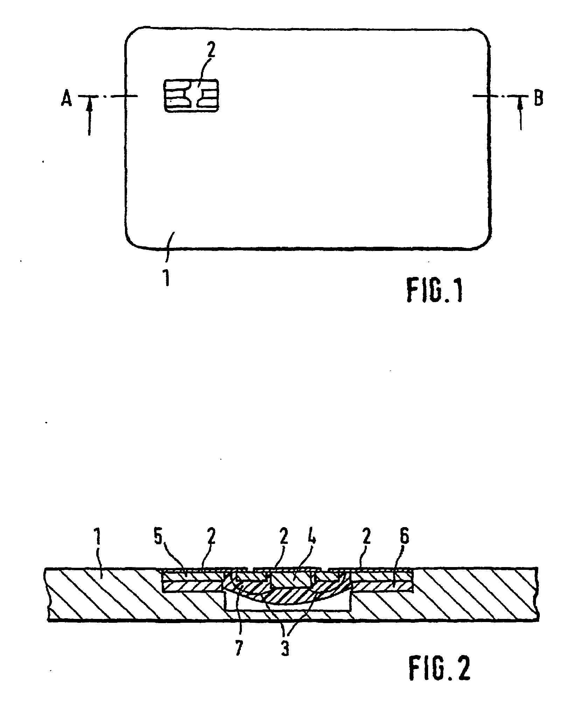

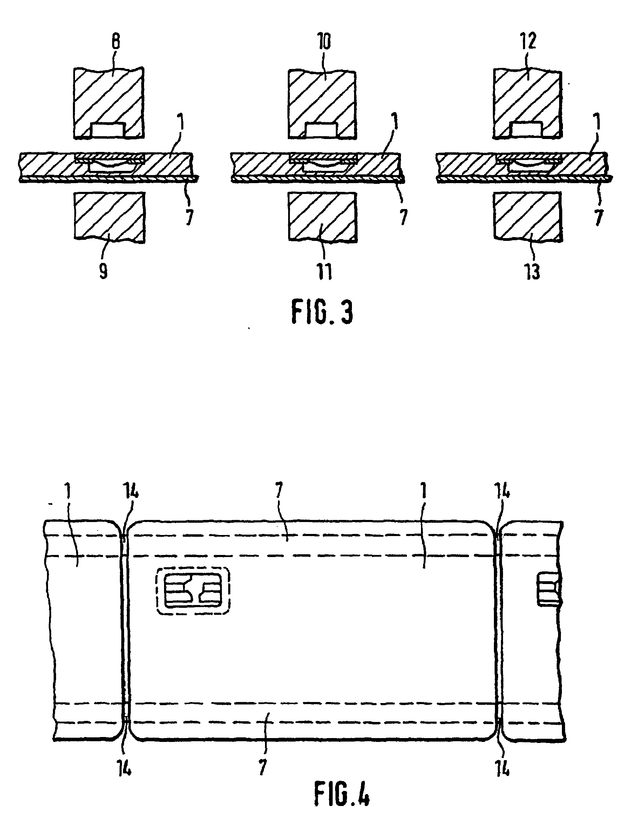

Fig. 1 zeigt einen Datenträger, der nach dem erfindungsgemäßen Verfahren hergestellt ist. Hierbei ist ein elektronisches Modul in einer zweistufigen Aussparung des Kartenkörpers 1 verklebt, wie dies Fig. 2 verdeutlicht.

Fig. 2 zeigt eine Schnittdarstellung eines Datenträgers gemäß Fig. 1 entlang der Schnittlinie A-B. Das elektronische Modul umfaßt einen Trägerfilm 5, auf dessen einer Seite sich die Kontaktflächen 2 befinden. In einem Fenster des Films 5 ist der integrierte Schaltkreis 4 untergebracht und über die Bonddrähtchen 3 durch weitere Fenster im Film 5 mit den Kontaktflächen 2 verbunden. Sowohl der integrierte Schaltkreis 4 wie auch die Bonddrähtchen 3 sind durch eine Vergußmasse 7 vergossen. Auf der den Kontaktflächen 2 gegenüberliegenden Seite des Films 5 ist ein Ring 6 aus thermoaktivierbarem Kleber angeordnet, der den Film 5 des elektronischen Moduls mit der Aussparung des Kartenkörpers 1 verklebt. Das Verkleben erfolgt hierbei, indem der thermoaktivierbare Kleber 6 erhitzt und das elektronische Modul mit dem Kartenkörper 1 verpreßt wird.

In einer nicht gezeigten Weiterbildung des Datenträgers kann das elektronische Modul auch durch das Kartenmaterial fixiert werden. In diesem Fall wird auf den Ring 6 aus thermoaktivierbarem Kleber verzichtet und der Film 5 weist zusätzliche Fenster auf, die das elektronische Modul verankern. Das Modul wird in der Aussparung des Kartenkörpers montiert, indem es unter Wärme und Druck in die Aussparung gepreßt wird, wobei das Kartenmaterial erweicht und in die Fenster im Film 5 eindringt.

Eine Schweißstation, um das elektronische Modul mit dem Kartenkörper 1 unter Wärme und Druck zu verpressen, zeigt Fig. 3. Die Schweißstation besteht aus den hintereinander angeordneten beheizbaren Stempeln 8 und 10 mit zugeordneten Kühlstempein 9 und 11 sowie einer weiteren Einheit, bestehend aus den gekühlten Stempeln 12 und 13. Darüber hinaus umfaßt die Schweißstation zwei Transportbänder 7, auf denen die Kartenkörper 1 mit bereits eingelegten elektronischen Modulen angeordnet sind. Die Transportbänder 7 sind in der Nähe der Längsseiten des Kartenkörpers 1 angeordnet, um ein Eingreifen der bezeichneten Stempel zwischen den Bändern zu ermöglichen, wie dies auch Fig. 4 zeigt. Zur exakten Positionierung des Kartenkörpers 1 in den einzelnen Bearbeitungsstationen weisen die Transportbänder 7 Mitnehmer 14 auf, zwischen denen der Kartenkörper 1 exakt positioniert ist. Seitlich werden die Kartenkörper 1 durch hier nicht gezeigte Führungsleisten positioniert.

Das Verkleben mit Hilfe der Schweißstation erfolgt wie folgt. Die Transportbänder positionieren den Kartenkörper 1 zwischen dem Heizstempel 8 und dem Kühlstempel 9, wo der Kartenkörper 1 mit dem Modul unter Wärme verpreßt und hierdurch derthermoaktivierbare Kleber 6 des Moduls bereits vorgewärmt wird. Hiernach transportieren die Transportbänder 7 den Kartenkörper 1 zur nächsten Einrichtung, wo das elektronische Modul mit dem Kartenkörper 1 durch den beheizbaren Stempel 10 und den Kühlstempel 11 derart erhitzt und verpreßt wird, so daß der thermoaktivierbare Kleber 6 schmilzt und hierdurch das elektronische Modul mit dem Kartenkörper 1 verklebt. Nach dem Verklebevorgang wird der Kartenkörper 1 von den Transportbändern 7 zur Kühleinrichtung transportiert, wo das elektronische Modul und der Kartenkörper 1 zwischen den Kühlstempeln 12 und 13 verpreßt und abgekühlt werden. Die Transportbänder 7 transportieren den Kartenkörper 1 so, daß der Kartenkörper 1 jeweils einmal pro Taktzeit in der nächstfolgenden Bearbeitungseinrichtung positioniert wird.

In einer nicht gezeigten Weiterbildung der Vorrichtung können der Heizstempel 8 und der Kühlstempel 9 durch eine Heizung ersetzt werden, die den Kartenkörper, das elektronische Modul und gegebenenfalls den thermoaktivierbaren Kleber teilweise umgeben und hierdurch gleichfalls in einem ersten Schritt vorwärmen.

Für den Fall, daß auf den thermoaktivierbaren Kleber des elektronischen Moduls verzichtet wird und das Substrat des Moduls anstatt dessen über zusätzliche Fenster zur Befestigung des Moduls mit dem Kartenkörper verfügt, wird das Verfahren, wie bereits erläutert, in völliger Analogie durchgeführt. Dementsprechend ist in diesem Fall auch die Vorrichtung analog augebaut.

## Patentansprüche

1. Verfahren zur Montage eines elektronischen Moduls in der Aussparung eines Kartenkörpers unter Anwendung von Wärme und Druck, wobei das Modul zunächst in den Kartenkörper eingesetzt wird, **dadurch gekennzeichnet, daß** anschließend die folgenden Schritte an wenigstens zwei hintereinander angeordneten Bearbeitungseinrichtungen durchgeführt werden:
- Durchführen eines ersten Arbeitsschrittes an der ersten Bearbeitungseinrichtung (8, 9) indem ein in der Aussparung angeordneter thermoaktivierbarer Kleber (6) oder der Kartenkörper (1) im Bereich des Moduls vorerwärmt wird,
- Transportieren des vorerwärmten Kartenkörpers (1) zu der zweiten Bearbeitungsvorrichtung (10,11),
- Durchführen eines zweiten Arbeitsschrittes an der zweiten Bearbeitungseinrichtung (10,11), um das Modul in dem Kartenkörper (1) zu fixieren, indem der thermoaktivierbare Kleber (6) oder das Kartenkörpermaterial so erhitzt wird, daß derthermoaktivierbare Kleber (6) oder das Kartenkörpermaterial erweicht, und auf das Modul zugleich Druck ausgeübt wird.

2. Verfahren nach Anspruch 1, **dadurch gekennzeichnet, daß** die Erwärmung im ersten Arbeitsschritt unter Druck geschieht.

3. Verfahren nach Anspruch 1 - Anspruch 2, **dadurch gekennzeichnet, daß** die Temperatur im ersten Arbeltsschritt geringer als im letzten Arbeitsschritt ist.

4. Verfahren nach Anspruch 1 - Anspruch 3, **dadurch gekennzeichnet, daß** in einem nach der Montage erfolgenden Arbeitsschritt das elektronische Modul und der Kartenkörper gekühlt werden.

## Claims

1. A method for mounting an electronic module in the gap in a card body using heat and pressure, the module being first inserted into the card body, **characterized in that** subsequently the following steps are performed on at least two tandem-mounted processing devices:
- performing a first working step on the first processing device (8, 9) by preheating a thermally activable adhesive (6) disposed in the gap, or the card body (1) in the area of the module,
- transporting the preheated card body (1) to the second processing device (10, 11),
- performing a second on the second processing device (10, 11) to fix the module in the card body (1) by heating the thermally activable adhesive (6) or the card body material so that the thermally activable adhesive (6) or the card body material softens, and at the same time exerting pressure on the module.

2. The method of claim 1, **characterized in that** the heating takes place under pressure in the first working step.

3. The method of claim 1 - claim 2, **characterized in that** the temperature is lower in the first working step than in the last working step.

4. The method of claim 1 - claim 3, **characterized in that** the electronic module and the card body are cooled in a working step taking place after mounting.

## Revendications

1. Procédé pour le montage d'un module électronique dans la cavité d'un corps de carte par application de chaleur et de pression, en insérant d'abord le module dans le corps de carte, **caractérisé en ce que** les opérations suivantes sont ensuite exécutées sur au moins deux postes de traitement disposés successivement:
- exécution d'une première opération sur le premier poste de traitement (8, 9) consistant à préchauffer une colle thermique (6) disposée dans la cavité ou le corps de carte (1) au niveau du module;
- transport du corps de carte (1) préchauffé vers le deuxième poste de traitement (10, 11);
- exécution d'une deuxième opération sur le deuxième poste de traitement (10, 11) afin de fixer le module dans le corps de carte (1), au cours de laquelle la colle thermique (6) ou le matériau du corps de carte est chauffé pour ramollir la colle thermique (6) ou le matériau du corps de carte, une pression étant exercée simultanément sur le module.

2. Procédé selon la revendication 1, **caractérisé en ce que** le préchauffage s'effectue sous pression lors de la première opération.

3. Procédé selon les revendications 1 et 2, **caractérisé en ce que** la température de la première opération est inférieure à celle de la dernière opération.

4. Procédé selon les revendications 1 à 3, **caractérisé en ce que** le module électronique et le corps de la carte sont refroidis au cours de l'une des opérations successives au montage.
